# EUROPEAN PATENT SPECIFICATION

(11) **EP 4 394 397 B1**
(45) Date of publication and mention of the grant of the patent: **11.02.2026**
(21) Application number: 22888935.8
(22) Date of filing: 11.08.2022
(51) Int. Cl.: G01R 19/00, G01R 15/20

(54) **IRON CORE-ANNULAR ARRAY MULTI-RING MAGNETOSENSITIVE CURRENT SENSOR AND CURRENT MEASUREMENT METHOD**
RINGFÖRMIGER MAGNETKERNARRAY-MULTIRING-MAGNETOSENSITIVER STROMSENSOR UND STROMMESSVERFAHREN
CAPTEUR DE COURANT MAGNÉTOSENSIBLE À ANNEAUX MULTIPLES À RÉSEAU ANNULAIRE - NOYAU DE FER ET PROCÉDÉ DE MESURE DE COURANT

(30) Priority: 04.11.2021 CN 202111299826; 04.11.2021 CN 202122683680 U
(43) Date of publication of application: 03.07.2024
(73) Proprietor: China Electric Power Research Institute, Beijing 100192 (CN); State Grid Zhejiang Electric Power Company Marketing Service Center, Hangzhou, Zhejiang 311121 (CN); China Electric Power Research Institute Wuhan Branch, Wuhan, Hubei 430070 (CN); State Grid Corporation of China, Beijing 100031 (CN)
(72) Inventor: ZHOU, Feng, Wuhan, Hubei 430070 (CN); YU, Jicheng, Wuhan, Hubei 430070 (CN); LEI, Min, Wuhan, Hubei 430070 (CN); YIN, Xiaodong, Wuhan, Hubei 430070 (CN); YUE, Changxi, Wuhan, Hubei 430070 (CN); LIANG, Siyuan, Wuhan, Hubei 430070 (CN); LI, Xiong, Hangzhou, Zhejiang 311121 (CN); LI, He, Wuhan, Hubei 430070 (CN); YAO, Li, Hangzhou, Zhejiang 311121 (CN); LI, Dengyun, Wuhan, Hubei 430070 (CN); LU, Chunguang, Hangzhou, Zhejiang 311121 (CN); XIAO, Tao, Hangzhou, Zhejiang 311121 (CN); XU, Zili, Wuhan, Hubei 430070 (CN); LIU, Wei, Hangzhou, Zhejiang 311121 (CN); ZHU, Kai, Wuhan, Hubei 430070 (CN); XIONG, Kui, Wuhan, Hubei 430070 (CN)
(74) Representative: White, Andrew John
(86) International application number: PCT/CN2022/111879
(87) International publication number: WO 2023/077900

(56) References cited:
- CN-A- 104 520 721
- CN-A- 106 018 919
- CN-A- 107 907 727
- CN-A- 110 297 119
- CN-A- 110 546 519
- CN-A- 112 362 941
- CN-A- 112 946 358
- CN-A- 113 447 699
- CN-A- 114 814 330
- CN-U- 205 210 163
- CN-U- 216 847 918
- JP-A- 2013 250 243
- US-A1- 2005 122 092
- US-A1- 2013 241 534
- US-A1- 2021 255 221

## Description

### TECHNICAL FIELD

The disclosure relates, but is not limited, to the technical field of electrical measurement, and particularly to an iron core annular array multi-ring magnetosensitive current sensor and a method for measuring a current.

Related technologies are known from US2013/241534A1 and US2021/255221A1.

### BACKGROUND

A conventional iron-core current sensor has been widely applied for current measurement in power systems. However, a measurement result may be affected due to poor linearity and temperature stability of the conventional iron-core current sensor, which is unsuitable for protecting an equal-width range requirement. A magnetic sensing array is an effective replacement for a magnetic sensor plus a magnetic core, and is an effective solution for problems such as space interference, magnetic core saturation, etc. With development of magnetic sensors such as a tunnel magnetoresistance (TMR) and a lowered cost thereof, it is possible to perform contactless current measurement using an array of magnetoresistance sensors, and a basic principle of the contactless current measurement is to measure a magnetic field based on Ampere current circuit law using multiple TMR sensors surrounding a current-carrying conductor, and a total of the magnetic sensors is an approximate closed loop. Advantages of measuring a current by using an annular magnetic sensor array are described as follows. The annular magnetic sensor array is in a structure with no iron core, and there is no saturation problem, thereby greatly improving a transient performance. Therefore, the annular magnetic sensor array can be widely applicable to various protecting failure measurements. However, a precision of an annular array current sensor is yet to be improved due to impact of factors such as crosstalk noise, etc.

### SUMMARY

The present invention is defined in the appended set of claims.

The disclosure provides an iron core annular array multi-ring magnetosensitive current sensor and a method for measuring a current, to solve a problem of how to measure a current and reduce a measurement error.

In view of this, an aspect of the disclosure provides an iron core annular array multi-ring magnetosensitive current sensor. The iron core annular array multi-ring magnetosensitive current sensor includes a first ring structure, a second ring structure, and a digital processing unit.

The first ring structure is sheathed on a conducting wire and is connected to the digital processing unit. The first ring structure is configured to acquire a feedback current signal generated by a first magnetic field signal produced according to a primary side current, and output the feedback current signal to the digital processing unit.

The second ring structure is sheathed on the conducting wire, and is connected to the digital processing unit. The second ring structure is configured to measure a second magnetic field signal generated by a current on the conducting wire in a coil of the second ring structure, and output the second magnetic field signal to the digital processing unit.

The digital processing unit is configured to determine a characteristic quantity characterizing the current on the conducting wire according to the feedback current signal and the second magnetic field signal, and determine the current on the conducting wire according to the characteristic quantity characterizing the current on the conducting wire.

In some embodiments, the first ring structure includes an iron core, a feedback current acquiring circuit, and a compensating winding.

The iron core may be an open iron core provided with two symmetrical air gaps. A first tunnel magnetoresistance (TMR) sensing chip is provided at each of the two air gaps, and is configured to measure the first magnetic field signal.

The feedback current acquiring circuit may be configured to average measured first magnetic field signals measured respectively by the two first TMR sensing chips to acquire an average first magnetic field signal, generate the feedback current signal based on the average first magnetic field signal, and output the feedback current signal to the compensating winding and the digital processing unit.

The compensating winding is wound evenly around the iron core, and configured to generate a compensating magnetic field according to the feedback current signal, superpose the compensating magnetic field and the first magnetic field signal, and control the iron core annular array multi-ring magnetosensitive current sensor to be kept in a zero magnetic flux state based on the superposed first magnetic field signal.

In some embodiments, the second ring structure includes four second tunnel magnetoresistance (TMR) sensing chips which are connected in parallel and provided symmetrically in an annular hollow housing at regular intervals. The four second TMR sensing chips may be configured to acquire the second magnetic field signal.

In some embodiments, a double-layered metal shielding layer is provided at an exterior of the annular hollow housing.

In some embodiments, the digital processing unit includes an analog-to-digital conversion module, a digital processing module, and a digital-to-analog conversion module.

The analog-to-digital conversion module is connected to the digital processing module, and is configured to perform analog-to-digital conversion on the feedback current signal and the second magnetic field signal, to obtain a digital feedback current signal and a digital second magnetic field signal.

The digital processing module is connected to the digital-to-analog conversion module, and is configured to compute a characteristic quantity characterizing the current on the conducting wire according to the digital feedback current signal and the digital second magnetic field signal.

The digital-to-analog conversion module is configured to perform digital-to-analog conversion on the characteristic quantity characterizing the current on the conducting wire to obtain an analog characteristic quantity, and determine the current on the conducting wire according to the analog characteristic quantity characterizing the current on the conducting wire.

In some embodiments, the iron core annular array multi-ring magnetosensitive current sensor further includes a power supply unit.

The power supply unit is configured to supply power to the first TRM sensing chips and the second TRM sensing chips.

Another aspect of the disclosure provides a method for measuring a current. The method is applied to an iron core annular array multi-ring magnetosensitive current sensor including a first ring structure, a second ring structure, and a digital processing unit. The method includes operations as follows.

The first ring structure acquires a feedback current signal produced by a first magnetic field signal generated according to a primary side current, and outputs the feedback current signal to the digital processing unit.

The second ring structure measures a second magnetic field signal generated by a current on a conducting wire in a coil of the second ring structure, and outputs the second magnetic field signal to the digital processing unit.

The digital processing unit determines a characteristic quantity characterizing the current on the conducting wire according to the feedback current signal and the second magnetic field signal, and determines the current on the conducting wire according to the characteristic quantity characterizing the current on the conducting wire.

In some embodiments, the first ring structure includes a compensating winding and a feedback current acquiring circuit. The compensating winding may be wound around an iron core. The method may further include operations as follows.

The feedback current acquiring circuit outputs the feedback current signal to the compensating winding and the digital processing unit.

The compensating winding generates a compensating magnetic field according to the feedback current signal, superpose the compensating magnetic field and the first magnetic field signal to acquire a superposed first magnetic field signal, and control the iron core annular array multi-ring magnetosensitive current sensor to be kept in a zero magnetic flux state based on the superposed first magnetic field signal.

In some embodiments, the first ring structure further includes an iron core. The iron core may be an open iron core with two symmetrical air gaps. A first tunnel magnetoresistance (TMR) sensing chip is provided at each of the two air gaps. The first ring structure acquiring the feedback current signal produced by the first magnetic field signal generated according to the primary side current includes operations as follows.

The first TMR sensing chip may measure the first magnetic field signal.

The feedback current acquiring circuit averages measured first magnetic field signals measured respectively by the two first TMR sensing chips to acquire an average first magnetic field signal, and generates the feedback current signal based on the average first magnetic field signal.

In some embodiments, the second ring structure includes four second tunnel magnetoresistance (TMR) sensing chips. The second ring structure measuring the second magnetic field signal generated by the current on the conducting wire in the coil of the second ring structure includes operations as follows.

The four second TMR sensing chips may acquire the second magnetic field signal. The four second TMR sensing chips may be connected in parallel and provided symmetrically at regular intervals in an annular hollow housing.

In some embodiments, a double-layered metal shielding layer is provided at an exterior of the annular hollow housing.

In some embodiments, the digital processing unit includes an analog-to-digital conversion module, a digital processing module, and a digital-to-analog conversion module. The digital processing unit determining the characteristic quantity characterizing the current on the conducting wire according to the feedback current signal and the second magnetic field signal includes operations as follows.

The analog-to-digital conversion module may perform analog-to-digital conversion on the feedback current signal and the second magnetic field signal, to obtain a digital feedback current signal and a digital second magnetic field signal.

The digital processing module may compute a characteristic quantity characterizing the current on the conducting wire according to the digital feedback current signal and the digital second magnetic field signal.

The determining the current on the conducting wire according to the characteristic quantity characterizing the current on the conducting wire includes operations as follows.

The digital-to-analog conversion module performs digital-to-analog conversion on the characteristic quantity characterizing the current on the conducting wire to obtain an analog characteristic quantity, and determines the current on the conducting wire according to the analog characteristic quantity characterizing the current on the conducting wire.

In some embodiments, the digital processing module computing the digital characteristic quantity characterizing the current on the conducting wire according to the digital feedback current signal and the digital second magnetic field signal includes at least one mode as follows.

In case the digital feedback current signal is within a first preset range, an eccentricity error in the digital feedback current signal is corrected based on the digital second magnetic field signal, to acquire the digital characteristic quantity characterizing the current on the conducting wire.

In case the digital feedback current signal is within a second preset range, a crosstalk error in the digital second magnetic field signal is corrected based on the digital feedback current signal, to acquire the digital characteristic quantity characterizing the current on the conducting wire.

In an application scene of transient response, the digital characteristic quantity characterizing the current on the conducting wire may be acquired based on an arithmetic mean of the digital second magnetic field signal.

In some embodiments, the iron core annular array multi-ring magnetosensitive current sensor further includes a power supply unit. The method may further include an operation as follows.

The power supply unit supplies power to the first TMR sensing chips and the second TMR sensing chips.

The disclosure provides an iron core annular array multi-ring magnetosensitive current sensor and a method for measuring a current. A feedback current signal produced by a first magnetic field signal generated according to a primary side current is acquired using a first ring structure. A second magnetic field signal generated by a current on a conducting wire in a coil is measured using a second ring structure. A characteristic quantity characterizing the current on the conducting wire is computed using a digital processing unit according to the feedback current signal and the second magnetic field signal, and the current on the conducting wire is determined according to the characteristic quantity characterizing the current on the conducting wire. The disclosure aims at a scenario of current measurement in a power system such as a DC distribution network, an electric vehicle DC charging pile, etc. A magnetosensitive element senses a magnetic field produced by a current to be measured using TMR sensing technology, an iron core with two air gaps is taken as a first ring structure, and an no-iron core annular array installed with multiple magnetosensitive chips is taken as a second ring structure, and a closed-loop feedback structure is devised based on a zero-flux principle, and a value of the current is determined by combining two measurement results through digital signal processing. The current sensor according to the disclosure combines advantages of both the iron core structure and the structure with no iron core, thereby effectively reducing impact of an eccentricity error, a crosstalk error, etc., expanding an application scope, and implementing accurate current measurement based on a tunnel magnetoresistance (TMR) element.

### BRIEF DESCRIPTION OF THE DRAWINGS

A more complete understanding of illustrative implementations of the disclosure may be achieved by referring to the drawings.
FIG. 1 is a schematic structural diagram of an iron core annular array multi-ring magnetosensitive current sensor 100 according to an embodiment of the disclosure.
FIG. 2 is a diagram of constitution of the iron core annular array multi-ring magnetosensitive current sensor according to an embodiment of the disclosure.
FIG. 3 is a diagram of a circuit principle of a first ring structure according to an embodiment of the disclosure.
FIG. 4 is a flowchart of a method 400 for measuring a current based on the iron core annular array multi-ring magnetosensitive current sensor according to an embodiment of the disclosure.

### DETAILED DESCRIPTION

Illustrative embodiments of the present disclosure are now introduced with reference to the drawings. However, the disclosure may be implemented in many different forms, and is not limited to embodiments illustrated here. The embodiments are provided to disclose the present disclosure thoroughly and completely, and fully deliver the scope of the disclosure to a person having ordinary skill in the art. Terms indicated in illustrative embodiments in the drawings do not limit the disclosure. In the drawings, identical reference signs are used for identical units/elements.

Unless otherwise stated, terms (including technical terms) used here have common meanings as understood by a person having ordinary skill in the art. In addition, understandably, a term defined by a common dictionary should be understood as having the same meaning as in context of related art of the term, and should not be understood as having an idealized or an overly formal meaning.

In related art, in order to reduce impact of a crosstalk error, a magnetic sensor array based on discrete Fourier transform (DFT) is adopted. A digital signal processing unit may be provided at an output part of an annular array sensor. A DFT-based signal processing algorithm may be devised in conjunction with an output signal of the sensor. The principle of the algorithm a Fourier expansion of a magnetic field around a conductor to be measured. An analytic expression of a Fourier coefficient may be acquired in existence of a uniform field in case the magnetic field is produced by a current perpendicularly passing through an array plane. The annular magnetic sensor array may map the magnetic field around the conductor to be measured, and implement spatial DFT of sensor data. A measured current value may be obtained by an inverse of a nonlinear system. The solution has the following disadvantages that the DFT-based magnetic sensor array model only takes a conductor with a circular section into account. However, as a magnetic field produced by a direct current (DC) flowing in a conductor with a rectangular section does not have radial symmetry, and the sensors in a circular array centered on a busbar cannot measure identical magnetic field values. If the sensor data is processed using the DFT algorithm, space harmonic of the magnetic field having a magnitude greater than zero is caused. The nonzero harmonics may also be attributed to a crosstalk field, and it may be difficult to distinguish between contributions from a current inside the array and contributions from a current outside the array. The annular array sensor does not implement enough accuracy since the flux concentrating effect of an iron core is lost, while the annular array sensor improved by the DFT algorithm provides a limited improvement in the accuracy of current measurement.

In another related art, a magnetosensitive current sensor with two Hall elements is adopted. An output signal of the sensor may change greatly when a location of the conductor (whose current is to be measured) in an annular magnetic circuit of the sensor changes, that is, a great location error is caused. In view of this, two air gaps may be provided on a magnetic circuit of the magnetosensitive current sensor. A Hall element and an appropriate signal processing component may be installed in each air gap to obtain a magnetosensitive current sensor having two Hall elements. The magnetic fields at the two Hall elements may differ due to a difference in the location of a conducting wire whose current is to be measured. Different Hall voltages are produced due to the different magnetic fields, and pass through a circuit parallel connection and are synthesized according to an equivalent circuit of a shunt capacitor. Then, an output of the sensor may be an arithmetic mean of outputs of the two Hall elements, which completely compensate for the location error. The solution has disadvantages that: in an aspect. since the iron core structure may be saturated, a nonlinear error of the saturated iron core structure may impact the scope and accuracy of current measurement, and the temperature stability of the iron core structure may also impact long-term usage of the sensor; in another aspect, a Hall sensor has inherent defects of low sensitivity, high power consumption, and poor linearity.

In view of this, the embodiments of the present disclosure provide an iron core annular array multi-ring magnetosensitive current sensor.

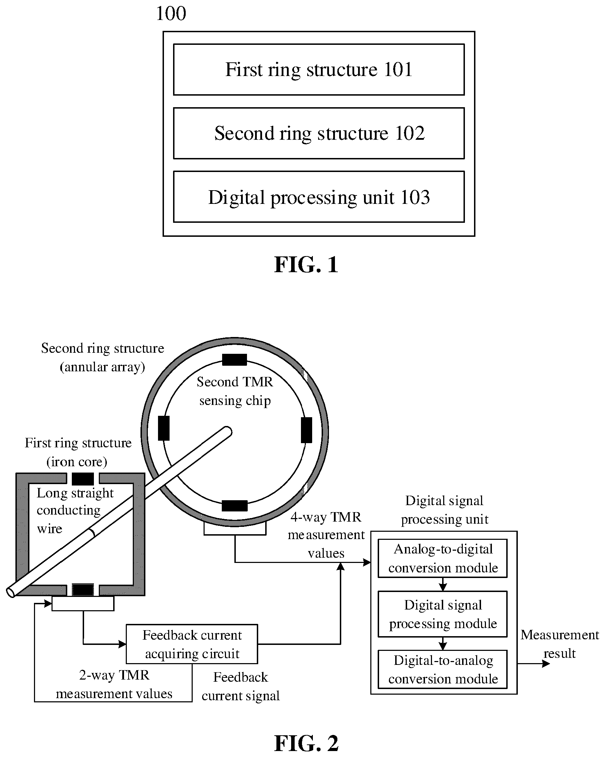

FIG. 1 is a schematic structural diagram of an iron core annular array multi-ring magnetosensitive current sensor 100 according to an embodiment of the disclosure. As illustrated in FIG. 1, the iron core annular array multi-ring magnetosensitive current sensor according to the embodiment of the disclosure may be applied to a current measurement scenario in a power system such as a DC distribution network, an electric vehicle DC charging pile, etc., in which, a magnetosensitive element is used to sense a magnetic field produced by a current to be measured based on tunnel magnetoresistance (TMR) sensing technology, a closed-loop feedback structure may be devised based on a zero-flux principle, taking an iron core with two air gaps as a first ring structure, and a no-iron-core ring installed with multiple magnetosensitive chips as a second ring structure, and a value of the current may be determined by combining two way measurement results through digital signal processing. The current sensor according to the disclosure combines advantages of both the iron core structure and the no-iron-core structure, thereby effectively reducing impact of an eccentricity error, a crosstalk error, etc., expanding an application scope, implementing accurate current measurement based on a TMR element. The iron core annular array multi-ring magnetosensitive current sensor 100 according to the embodiment of the disclosure includes a first ring structure 101, a second ring structure 102, and a digital processing unit 103.

In some embodiments, the first ring structure 101 is sheathed on a conducting wire, and is connected to the digital processing unit. The first ring structure 101 is configured to acquire a feedback current signal produced by a first magnetic field signal generated according to a primary side current, and output the feedback current signal to the digital processing unit.

In some embodiments, the first ring structure includes an iron core, a feedback current acquiring circuit, and a compensating winding.

The iron core may be an open iron core provided with two symmetrical air gaps. A first tunnel magnetoresistance (TMR) sensing chip may be provided at each of the two air gaps, and be configured to measure the first magnetic field signal.

The feedback current acquiring circuit may be configured to: average first magnetic field signals measured respectively by the two first TMR sensing chips to obtain an average first magnetic field signal; generate the feedback current signal through an amplifier in the feedback current acquiring circuit based on the average first magnetic field signal; and output the feedback current signal to the compensating winding and the digital processing unit.

The compensating winding is wound evenly around the iron core, and are configured to generate a compensating magnetic field according to the feedback current signal, superpose the compensating magnetic field and the first magnetic field signal to acquire a superposed first magnetic field signal, and control the iron core annular array multi-ring magnetosensitive current sensor to be kept in a zero magnetic flux state based on the superposed first magnetic field signal.

In some embodiments, the sensor further includes a power supply unit.

The power supply unit may be configured to power the first TMR sensing chips.

Referring to FIG. 2, in the present disclosure, the first ring structure may include an iron core, a feedback current acquiring circuit, and a compensating winding. The iron core may be an open iron core provided with two symmetrical air gaps. A first TMR sensing chip may be installed at each air gap. The first TMR sensing chip may be configured to measure the magnetic field produced by the primary side current. The first TMR sensing chip may be powered by the power supply unit (not shown). The feedback current acquiring circuit in the first ring structure may average measured first magnetic field signals measured by the two first TMR sensing chips through a parallel circuit, output an average result to the operational amplifier, and generate the feedback current through the operational amplifier, and output the feedback current to the compensating winding and the digital signal processing unit. The compensating winding in the first ring structure may be wound evenly around the iron core, and configured to receive the feedback current generated by the feedback current acquiring circuit, to generate a compensating magnetic field, and superpose the compensating magnetic field and the magnetic field produced by the primary side current to keep the sensor to be in a zero magnetic flux state.

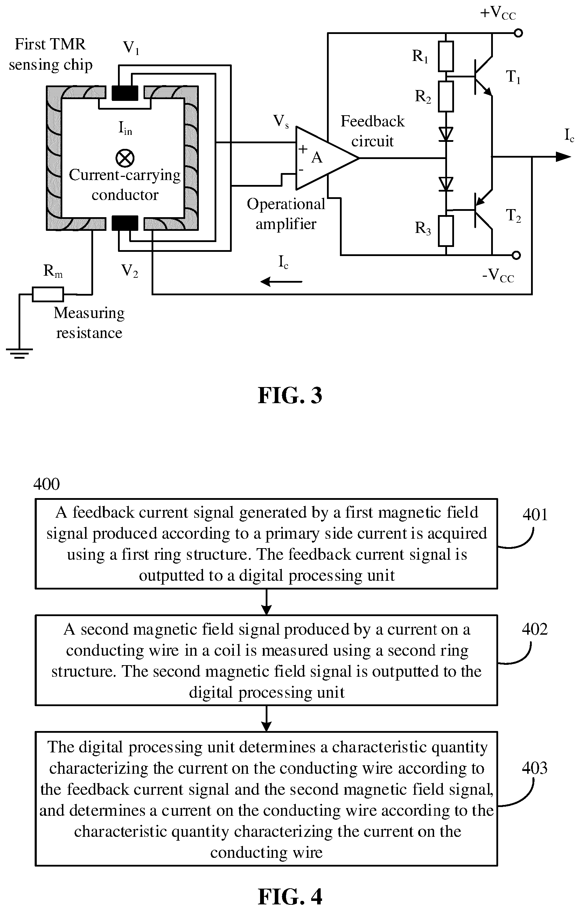

In some embodiments, the circuit of the first ring structure is as illustrated in FIG. 3. The feedback current acquiring circuit in the first ring structure may first average the measurement results of the two TMR sensing chips through the parallel circuit, then generate the feedback current through the operational amplifier and a feedback circuit, and input the feedback current to the compensating winding and the digital signal processing unit.

In some embodiments, the second ring structure 102 is sheathed on the conducting wire, and is connected to the digital processing unit. The second ring structure 102 is configured to measure a second magnetic field signal generated by a current on the conducting wire in a coil, and output the second magnetic field signal to the digital processing unit.

In some embodiments, the second ring structure includes four second tunnel magnetoresistance (TMR) sensing chips which are connected in parallel and provided symmetrically at regular intervals in an annular hollow housing. The second TMR sensing chip is configured to acquire the second magnetic field signal.

In some embodiments, a double-layered metal shielding layer is provided at an exterior of the annular hollow housing.

In some embodiments, the sensor further includes a power supply unit.

The power supply unit is configured to supply power to the second TMR sensing chips.

Referring to FIG. 2, in the disclosure, the second ring structure may include four second TMR sensing chips which are installed symmetrically at regular intervals in an annular hollow housing. A double-layered metal shielding layer may be provided on the outside of the annular hollow housing. The second ring structure may measure the magnetic field produced by the current in the coil by using the four second TMR sensing chips, and output the obtained four second magnetic field signals to the digital signal processing unit. The second TMR sensing chips may be powered by the power supply unit (not shown).

In some embodiments, the digital processing unit 103 is configured to compute a characteristic quantity characterizing the current on the conducting wire according to the feedback current signal and the second magnetic field signal, and determine the current on the conducting wire according to the characteristic quantity characterizing the current on the conducting wire.

In some embodiments, the digital processing unit includes an analog-to-digital conversion module, a digital processing module, and a digital-to-analog conversion module.

The analog-to-digital conversion module may be connected to the digital processing module, and be configured to perform analog-to-digital conversion on the feedback current signal and the second magnetic field signal, to acquire a digital feedback current signal and a digital second magnetic field signal.

The digital processing module may be connected to the digital-to-analog conversion module, and be configured to compute a characteristic quantity characterizing the current on the conducting wire according to the digital feedback current signal and the digital second magnetic field signal.

The digital-to-analog conversion module may be configured to perform digital-to-analog conversion on the characteristic quantity characterizing the current on the conducting wire to acquire an analog characteristic quantity characterizing the current on the conducting wire, and determine the current on the conducting wire according to the analog characteristic quantity characterizing the current on the conducting wire.

In some embodiments, the operation that the digital processing module calculates a characteristic quantity characterizing the current on the conducting wire according to the digital feedback current signal and the digital second magnetic field signal includes the following operations.

In case the digital feedback current signal is within a first preset range, an eccentricity error in the digital feedback current signal is corrected based on the digital second magnetic field signal, to obtain the characteristic quantity characterizing the current on the conducting wire.

In case the digital feedback current signal is within a second preset range, a crosstalk error in the digital second magnetic field signal is corrected based on the digital feedback current signal, to obtain the characteristic quantity characterizing the current on the conducting wire.

In an application scenario of transient response, an arithmetic mean may be calculated based on the second magnetic field signal to acquire the characteristic quantity characterizing the current on the conducting wire.

In the disclosure, the digital signal processing unit 103 may include an analog-to-digital conversion module, a digital signal processing module, and a digital-to-analog conversion module. In the analog-to-digital conversion module, signals (the feedback current signal and the four second magnetic field signals) measured by the two rings are sampled at a high speed through a 12-bit analog-to-digital (A/D) converter on chip, sample data is converted into a digital signal, and the digital signal is inputted to the digital signal processing module, and the digital signal processing module calculates and outputs the characteristic quantity characterizing the current on the conducting wire \.

In the disclosure, when the characteristic quantity characterizing the current on the conducting wire is calculated through the digital signal processing module, the first ring structure may be taken as a primary ring and correction may be made using the second ring structure for a low range part; and the second ring structure may be taken as the primary ring and correction may be made using the first ring structure for a high range part, and a transient sensing function may be implemented by the second ring structure. The digital signal processing module may implement functions as follows. Within the low range, the measurement result of the first ring structure is primary, and an eccentricity error is corrected using measurement results of the four TMR sensing chips of the second ring structure. Within the high range, the measurement result of the second ring structure is primary, and a crosstalk error is corrected using the measurement results of the first ring structure. In the application scenario of transient response, the arithmetic mean of the measurement results of the four second TMR sensing chips of the second ring structure may be calculated directly and output.

In the disclosure, upon receiving the characteristic quantity characterizing the current on the conducting wire outputted by the digital signal processing module, the digital-to-analog conversion module in the digital signal processing unit may convert the characteristic quantity into an analogue voltage signal, and output the analogue voltage signal as a final output of the sensor. The value of the current on the measured conducting wire may be determined based on the analogue voltage signal outputted by the sensor.

In the iron core annular array multi-ring magnetosensitive current sensor according to the disclosure, a first ring structure may be the open iron core with two air gaps having the compensating winding, and measures a superposed magnetic field produced by a primary current and a feedback current to implement a sensing function. A second ring structure may be a magnetic sensing annular array that implements fast measurement and reduces an eccentricity error. A digital signal processing unit combines measurement results of the two rings to correct errors and expand a measurement scope in different application scenarios. By applying the disclosure, a high-precision current sensor suitable for a wide filed such as power system measurement and protection, etc., is developed.

FIG. 4 is a flowchart of a method 400 for measuring a current based on the iron core annular array multi-ring magnetosensitive current sensor according to an embodiment of the disclosure. As illustrated in FIG. 4, the method 400 for measuring a current based on the above iron core annular array multi-ring magnetosensitive current sensor according to the embodiment of the disclosure includes operations as follows.

In operation 401, a feedback current signal generated by a first magnetic field signal produced according to a primary side current is acquired using a first ring structure, and the feedback current signal is outputted to a digital processing unit.

In some embodiments, the operation that the feedback current signal generated by the first magnetic field signal produced according to the primary side current is acquired using the first ring structure includes operations as follows.

The first magnetic field signal may be measured using a first TMR sensing chip provided at each of two symmetrical air gaps of an open iron core.

An average first magnetic field signal may be acquired by averaging first magnetic field signals measured by the two first TMR sensing chips using a feedback current acquiring circuit. The feedback current signal may be generated through an amplifier based on the average first magnetic field signal. The feedback current signal may be outputted to the compensating winding and the digital processing unit.

A compensating magnetic field may be generated according to the feedback current signal using the compensating winding wound around the iron core. The compensating magnetic field and the first magnetic field signal may be superposed to acquire a superposed first magnetic field signal. The iron core annular array multi-ring magnetosensitive current sensor may be kept to be in the zero magnetic flux state based on the superposed first magnetic field signal.

In operation 402, a second magnetic field signal generated by a current on a conducting wire in a coil is measured using a second ring structure. The second magnetic field signal is outputted to the digital processing unit.

In some embodiments, the operation that the second magnetic field signal generated by the current on the conducting wire in the coil is measured using the second ring structure includes operations as follows.

The second magnetic field signal may be acquired using four second TMR sensing chips. The four second TMR sensing chips may be connected in parallel and provided symmetrically at regular intervals in an annular hollow housing.

In some embodiments, a double-layered metal shielding layer is provided at an exterior of the annular hollow housing.

In operation 403, a characteristic quantity characterizing the current on the conducting wire is determined using the digital processing unit according to the feedback current signal and the second magnetic field signal. The current on the conducting wire is determined according to the characteristic quantity characterizing the current on the conducting wire.

In some embodiments, the operation that the characteristic quantity characterizing the current on the conducting wire is calculated using the digital processing unit according to the feedback current signal and the second magnetic field signal includes operations as follows.

Analog-to-digital conversion is performed on the feedback current signal and the second magnetic field signal using an analog-to-digital conversion module, to obtain a digital feedback current signal and a digital second magnetic field signal.

A characteristic quantity characterizing the current on the conducting wire is calculated according to the digital feedback current signal and the digital second magnetic field signal using a digital processing module.

Digital-to-analog conversion is performed on the characteristic quantity characterizing the current on the conducting wire by using a digital-to-analog conversion module, to obtain an analog characteristic quantity characterizing the current on the conducting wire. The current on the conducting wire may be determined according to the analog characteristic quantity characterizing the current on the conducting wire.

In some embodiments, the operation that the characteristic quantity characterizing the current on the conducting wire is calculated according to the digital feedback current signal and the digital second magnetic field signal using the digital processing module includes operations as follows.

In case the digital feedback current signal is within a first preset range, an eccentricity error in the digital feedback current signal is corrected based on the digital second magnetic field signal, to obtain the characteristic quantity characterizing the current on the conducting wire. The first preset range may represent a low range. In some embodiments, a corrected digital feedback current signal is determined as the characteristic quantity characterizing the current on the conducting wire.

In case the digital feedback current signal is within a second preset range, a crosstalk error in the digital second magnetic field signal is corrected based on the digital feedback current signal, to obtain the characteristic quantity characterizing the current on the conducting wire. The second preset range may represent a high range. In some embodiments, a corrected digital second magnetic field signal is determined as the characteristic quantity characterizing the current on the conducting wire.

In an application scenario of transient response, the characteristic quantity characterizing the current on the conducting wire may be acquired based on an arithmetic mean of the digital second magnetic field signal. In some embodiments, the arithmetic mean of the digital second magnetic field signal is determined as the characteristic quantity characterizing the current on the conducting wire.

In some embodiments, the method further includes an operation as follows.

The first TMR sensing chips and the second TMR sensing chips may be powered using a power supply unit.

The method 400 for measuring a current based on the iron core annular array multi-ring magnetosensitive current sensor according to an embodiment of the disclosure corresponds to the iron core annular array multi-ring magnetosensitive current sensor 100 according to another embodiment of the disclosure.

The disclosure is described with reference to a few embodiments. However, a person having ordinary skill in the art knows that embodiments other than those disclosed herein, as defined in the appended claims, fall within the scope of the disclosure as well.

In general, all terms used in the claims are construed as commonly understood in the art, unless explicitly defined otherwise herein. Any reference to "a/an/the/said apparatus, component or the like" is inclusively construed as at least one instance of the apparatus, component or the like, unless explicitly illustrated otherwise. Operations of any method herein do not have to be performed in an exact order disclosed, unless explicitly so illustrated.

A person having ordinary skill in the art should understand that the embodiments of the disclosure may be provided as a method, a system, or a computer-program product. Therefore, the embodiments of the disclosure may be implemented in form of fully hardware, fully software, or a combination of hardware and software. Moreover, one or more embodiments of the disclosure may be in the form of a computer-program product implemented on one or more computer-usable storage media (including, but not limited to disk memory, CD-ROM, or optical memory, etc.) containing computer-usable program codes.

The present disclosure is illustrated with reference to flowcharts and/or block diagrams of the method, device (system) and computer-program product according to embodiments of the disclosure. It should be understood that each flow in the flowcharts and/or each block in the block diagrams as well as combination of flows in the flowcharts and/or blocks in the block diagrams may be implemented by instructions of a computer program. Such computer instructions may be provided in a processor of a general-purpose computer, an application-specific computer, an embedded processor or other programmable data processing devices to generate a machine, such that a device with a function specified in one or more flows of the flowcharts and/or one or more blocks in the block diagrams is generated by instructions executed by a processor of a computer or other programmable data processing devices.

These computer program instructions may also be stored in a computer-readable memory which is capable of enabling a computer or another programmable data processing device to operate in a given way, such that the instructions stored in the computer-readable memory generate a manufactured good including an instruction apparatus for implementing a function specified in one or more flows of the flowcharts and/or one or more blocks in the block diagrams.

The computer-program instructions may also be loaded in a computer or other programmable data processing devices, to enable the computer or other programmable data processing devices to execute a series of operations to generate computer-implemented processing, such that the instructions executed on the computer or other programmable data processing devices provide the operations for implementing the function specified in one or more flows of the flowcharts or one or more blocks in the block diagrams.

Finally, it should be noted that the embodiments are merely for explaining a technical solution of the present disclosure, and are not intended to limit the present disclosure. The present disclosure is elaborated with reference to the above embodiments. A person having ordinary skill in the art may make a modification and/or equivalent replacement to an embodiment of the disclosure without departing from the spirit and scope of the disclosure, and any such modification and/or equivalent replacement should be covered by the claims of the disclosure.

### Industrial Applicability

The embodiments of the present disclosure provide an iron core annular array multi-ring magnetosensitive current sensor and a method for measuring a current. The iron core annular array multi-ring magnetosensitive current sensor includes a first ring structure, a second ring structure, and a digital processing unit. The first ring structure is sheathed on a conducting wire, and is connected to the digital processing unit. The first ring structure is configured to acquire a feedback current signal produced by a first magnetic field signal generated according to a primary side current, and output the feedback current signal to the digital processing unit. The second ring structure is sheathed on the conducting wire, and is connected to the digital processing unit. The second ring structure is configured to measure a second magnetic field signal generated by a current on the conducting wire in a coil of the second ring structure, and output the second magnetic field signal to the digital processing unit. The digital processing unit is configured to determine a characteristic quantity characterizing the current on the conducting wire according to the feedback current signal and the second magnetic field signal, and determine the current on the conducting wire according to the characteristic quantity characterizing the current on the conducting wire. The current sensor according to the disclosure combines advantages of both the iron core structure and the non-iron-core structure, thereby effectively reducing impact of an eccentricity error, a crosstalk error or the like expanding an application scope, implementing accurate current measurement based on a tunnel magnetoresistance (TMR) element.

## Claims

1. An iron core annular array multi-ring magnetosensitive current sensor, **characterized in that** the sensor comprises a first ring structure (101), a second ring structure (102), and a digital processing unit (103),
wherein the first ring structure (101) is sheathed on a conducting wire, and is connected to the digital processing unit (103), and the first ring structure (101) is configured to acquire a feedback current signal generated by a first magnetic field signal produced according to a current on the conducting wire in an iron core of the first ring structure (101), and output the feedback current signal to the digital processing unit (103),
wherein the second ring structure (102) is sheathed on the conducting wire, and is connected to the digital processing unit (103), and the second ring structure (102) is configured to measure a second magnetic field signal produced by a current on the conducting wire in a coil of the second ring structure (102), and output the second magnetic field signal to the digital processing unit (103), and
wherein the digital processing unit (103) is configured to determine a characteristic quantity characterizing the current on the conducting wire according to the feedback current signal and the second magnetic field signal, and determine the current on the conducting wire according to the characteristic quantity characterizing the current on the conducting wire,
wherein the first ring structure (101) comprises the iron core, a feedback current acquiring circuit, and a compensating winding,
wherein the iron core is an open iron core provided with two symmetrical air gaps, wherein a first tunnel magnetoresistance (TMR) sensing chip is provided at each of the two air gaps, and is configured to measure the first magnetic field signal,
wherein the feedback current acquiring circuit is configured to average the first magnetic field signals measured by the two first TMR sensing chips to acquire an average first magnetic field signal, generate the feedback current signal based on the average first magnetic field signal, and output the feedback current signal to the compensating winding and the digital processing unit (103),
wherein the compensating winding is wound evenly around the iron core, and configured to produce a compensating magnetic field according to the feedback current signal, superpose the compensating magnetic field and the first magnetic field signal to acquire a superposed first magnetic field signal, and keep the iron core annular array multi-ring magnetosensitive current sensor to be in a zero magnetic flux state based on the superposed first magnetic field signal.

2. The iron core annular array multi-ring magnetosensitive current sensor of claim 1, wherein the second ring structure (102) comprises four second tunnel magnetoresistance (TMR) sensing chips which are connected in parallel and provided symmetrically at regular intervals in an annular hollow housing, wherein the second TMR sensing chips are configured to acquire the second magnetic field signal.

3. The iron core annular array multi-ring magnetosensitive current sensor of claim 2, wherein a double-layered metal shielding layer is provided at an exterior of the annular hollow housing.

4. The iron core annular array multi-ring magnetosensitive current sensor of any one of claims 1 to 3, wherein the digital processing unit (103) comprises an analog-to-digital conversion module, a digital processing module, and a digital-to-analog conversion module,
wherein the analog-to-digital conversion module is connected to the digital processing module, and is configured to perform analog-to-digital conversion on the feedback current signal and the second magnetic field signal to acquire a digital feedback current signal and a digital second magnetic field signal,
wherein the digital processing module is connected to the digital-to-analog conversion module, and is configured to calculate a characteristic quantity characterizing the current on the conducting wire according to the digital feedback current signal and the digital second magnetic field signal,
wherein the digital-to-analog conversion module is configured to perform digital-to-analog conversion on the characteristic quantity characterizing the current on the conducting wire to acquire an analog characteristic quantity characterizing the current on the conducting wire, and determine the current on the conducting wire according to the analog characteristic quantity characterizing the current on the conducting wire.

5. The iron core annular array multi-ring magnetosensitive current sensor of claim 1 or 2, further comprising a power supply unit,
wherein the power supply unit is configured to supply power to the first TMR sensing chips and the second TMR sensing chips.

6. A method for measuring a current, applied to an iron core annular array multi-ring magnetosensitive current sensor comprising a first ring structure, a second ring structure, and a digital processing unit, **characterized in that** the method comprises:
acquiring, by the first ring structure, a feedback current signal generated by a first magnetic field signal produced according to a current on a conducting wire in an iron core of the first ring structure, and outputting, by the first ring structure, the feedback current signal to the digital processing unit (401);
measuring, by the second ring structure, a second magnetic field signal produced by a current on the conducting wire in a coil of the second ring structure, and outputting, by the second ring structure, the second magnetic field signal to the digital processing unit (402); and
determining, by the digital processing unit, a characteristic quantity characterizing the current on the conducting wire according to the feedback current signal and the second magnetic field signal, and determining the current on the conducting wire according to the characteristic quantity characterizing the current on the conducting wire (403)
wherein the first ring structure comprises a compensating winding and a feedback current acquiring circuit, and the compensating winding is wound around an iron core, wherein the method further comprises:
outputting, by the feedback current acquiring circuit, the feedback current signal to the compensating winding and the digital processing unit; and
generating, by the compensating winding, a compensating magnetic field according to the feedback current signal, superposing the compensating magnetic field and the first magnetic field signal to acquire a superposed first magnetic field signal, and keeping the iron core annular array multi-ring magnetosensitive current sensor to be in a zero magnetic flux state based on the superposed first magnetic field signal,
wherein the first ring structure further comprises the iron core, wherein the iron core is an open iron core provided with two symmetrical air gaps, and a first tunnel magnetoresistance (TMR) sensing chip is provided at each of the two air gaps,
wherein acquiring, by the first ring structure, the feedback current signal generated by the first magnetic field signal produced according to the current on the conducting wire (401) comprises:
measuring, by each of the first TMR sensing chips, the first magnetic field signal;
and
averaging, by the feedback current acquiring circuit, the first magnetic field signals measured by the two first TMR sensing chips, to acquire an average first magnetic field signal, and generating the feedback current signal based on the average first magnetic field signal.

7. The method of claim 6, wherein the second ring structure comprises four second tunnel magnetoresistance (TMR) sensing chips,
wherein measuring, by the second ring structure, the second magnetic field signal produced by the current on the conducting wire in the coil of the second ring structure (402) comprises:
acquiring, by the four second TMR sensing chips, the second magnetic field signal, wherein the four second TMR sensing chips are connected in parallel and provided symmetrically at regular intervals in an annular hollow housing.

8. The method of claim 7, wherein a double-layered metal shielding layer is provided at an exterior of the annular hollow housing.

9. The method of any one of claims 6 to 8, wherein the digital processing unit comprises an analog-to-digital conversion module, a digital processing module, and a digital-to-analog conversion module,
wherein determining, by the digital processing unit, the characteristic quantity characterizing the current on the conducting wire according to the feedback current signal and the second magnetic field signal (403) comprises:
performing, by the analog-to-digital conversion module, analog-to-digital conversion on the feedback current signal and the second magnetic field signal, to acquire a digital feedback current signal and a digital second magnetic field signal; and
calculating, by the digital processing module, a characteristic quantity characterizing the current on the conducting wire according to the digital feedback current signal and the digital second magnetic field signal,
wherein determining the current on the conducting wire according to the characteristic quantity characterizing the current on the conducting wire (403) comprises:
performing, by the digital-to-analog conversion module, digital-to-analog conversion on the characteristic quantity characterizing the current on the conducting wire, to acquire an analog characteristic quantity characterizing the current on the conducting wire, and determining the current on the conducting wire according to the analog characteristic quantity characterizing the current on the conducting wire.

10. The method of claim 9, wherein calculating, by the digital processing module, the characteristic quantity characterizing the current on the conducting wire according to the digital feedback current signal and the digital second magnetic field signal comprises at least one of:
in response to the digital feedback current signal being within a first preset range, correcting an eccentricity error in the digital feedback current signal based on the digital second magnetic field signal, to acquire the characteristic quantity characterizing the current on the conducting wire;
in response to the digital feedback current signal being within a second preset range, correcting a crosstalk error in the digital second magnetic field signal based on the digital feedback current signal, to acquire the characteristic quantity characterizing the current on the conducting wire; or
in an application scenario of transient response, acquiring the characteristic quantity characterizing the current on the conducting wire based on an arithmetic mean of the digital second magnetic field signal.

11. The method of claim 6 or 7, wherein the iron core annular array multi-ring magnetosensitive current sensor further comprises a power supply unit, wherein the method further comprises:
powering, by the power supply unit, the first TMR sensing chips and the second TMR sensing chips.

## Patentansprüche

1. Magnetosensitiver Eisenkern-Ringarray-Mehrring-Stromsensor, **dadurch gekennzeichnet, dass** der Sensor eine erste Ringstruktur (101), eine zweite Ringstruktur (102) und eine digitale Verarbeitungseinheit (103) umfasst,
wobei die erste Ringstruktur (101) auf einen leitenden Draht aufgeschoben ist und mit der digitalen Verarbeitungseinheit (103) verbunden ist, und die erste Ringstruktur (101) konfiguriert ist, um ein Rückkopplungsstromsignal zu erfassen, das durch ein erstes Magnetfeldsignal erzeugt wird, das entsprechend einem Strom auf dem leitenden Draht in einem Eisenkern der ersten Ringstruktur (101) erzeugt wird, und das Rückkopplungsstromsignal an die digitale Verarbeitungseinheit (103) auszugeben,
wobei die zweite Ringstruktur (102) auf den leitenden Draht aufgeschoben ist und mit der digitalen Verarbeitungseinheit (103) verbunden ist, und die zweite Ringstruktur (102) konfiguriert ist, um ein zweites Magnetfeldsignal zu messen, das durch einen Strom auf dem leitenden Draht in einer Spule der zweiten Ringstruktur (102) erzeugt wird, und das zweite Magnetfeldsignal an die digitale Verarbeitungseinheit (103) auszugeben, und
wobei die digitale Verarbeitungseinheit (103) konfiguriert ist, um eine charakteristische Größe, die den Strom auf dem leitenden Draht charakterisiert, gemäß dem Rückkopplungsstromsignal und dem zweiten Magnetfeldsignal zu bestimmen, und den Strom auf dem leitenden Draht gemäß der charakteristischen Größe, die den Strom auf dem leitenden Draht charakterisiert, zu bestimmen,
wobei die erste Ringstruktur (101) den Eisenkern, eine Rückkopplungsstrom-Erfassungsschaltung und eine Kompensationswicklung umfasst,
wobei der Eisenkern ein offener Eisenkern ist, der mit zwei symmetrischen Luftspalten bereitgestellt wird, wobei ein erster Erfassungschip für magnetischen Tunnelwiderstand (TMR-Erfassungschip) an jedem der zwei Luftspalte bereitgestellt wird und konfiguriert ist, um das erste Magnetfeldsignal zu messen,
wobei die Rückkopplungsstrom-Erfassungsschaltung konfiguriert ist, um die ersten Magnetfeldsignale, die von den zwei ersten TMR-Erfassungschips gemessen werden, zu mitteln, um ein gemitteltes erstes Magnetfeldsignal zu erfassen, das Rückkopplungsstromsignal basierend auf dem gemittelten ersten Magnetfeldsignal zu erzeugen und das Rückkopplungsstromsignal an die Kompensationswicklung und die digitale Verarbeitungseinheit (103) auszugeben,
wobei die Kompensationswicklung gleichmäßig um den Eisenkern gewickelt ist und konfiguriert ist, um ein kompensierendes Magnetfeld entsprechend dem Rückkopplungsstromsignal zu erzeugen, das kompensierende Magnetfeld und das erste Magnetfeldsignal zu überlagern, um ein überlagertes erstes Magnetfeldsignal zu erfassen, und den magnetosensitiven Eisenkern-Ringarray-Mehrring-Stromsensor basierend auf dem überlagerten ersten Magnetfeldsignal in einem Null-Magnetfluss-Zustand zu halten.

2. Magnetosensitiver Eisenkern-Ringarray-Mehrring-Stromsensor nach Anspruch 1, wobei die zweite Ringstruktur (102) vier zweite Erfassungschips für magnetischen Tunnelwiderstand (TMR-Erfassungschips) umfasst, die parallel geschaltet und symmetrisch in regelmäßigen Abständen in einem ringförmigen hohlen Gehäuse bereitgestellt sind, wobei die zweiten TMR-Erfassungschips konfiguriert sind, um das zweite Magnetfeldsignal zu erfassen.

3. Magnetosensitiver Eisenkern-Ringarray-Mehrring-Stromsensor nach Anspruch 2, wobei eine doppelschichtige Metallabschirmschicht an einer Außenseite des ringförmigen hohlen Gehäuses bereitgestellt ist.

4. Magnetosensitiver Eisenkern-Ringarray-Mehrring-Stromsensor nach einem der Ansprüche 1 bis 3, wobei die digitale Verarbeitungseinheit (103) ein Analog-Digital-Wandlermodul, ein digitales Verarbeitungsmodul und ein Digital-Analog-Wandlermodul umfasst,
wobei das Analog-Digital-Wandlermodul mit dem digitalen Verarbeitungsmodul verbunden ist und konfiguriert ist, um eine Analog-DigitalWandlung an dem Rückkopplungsstromsignal und dem zweiten Magnetfeldsignal durchzuführen, um ein digitales Rückkopplungsstromsignal und ein digitales zweites Magnetfeldsignal zu erfassen,
wobei das digitale Verarbeitungsmodul mit dem Digital-Analog-Wandlermodul verbunden ist und konfiguriert ist, um eine charakteristische Größe, die den Strom auf dem leitenden Draht charakterisiert, gemäß dem digitalen Rückkopplungsstromsignal und dem digitalen zweiten Magnetfeldsignal zu berechnen,
wobei das Digital-Analog-Wandlermodul konfiguriert ist, eine Digital-Analog-Wandlung an der charakteristischen Größe, die den Strom auf dem leitenden Draht charakterisiert, durchzuführen, um eine analoge charakteristische Größe zu erfassen, die den Strom auf dem leitenden Draht charakterisiert, und den Strom auf dem leitenden Draht gemäß der analogen charakteristischen Größe, die den Strom auf dem leitenden Draht charakterisiert, zu bestimmen.

5. Magnetosensitiver Eisenkern-Ringarray-Mehrring-Stromsensor nach Anspruch 1 oder 2, ferner umfassend eine Stromversorgungseinheit,
wobei die Stromversorgungseinheit konfiguriert ist, um Strom an die ersten TMR-Erfassungschips und die zweiten TMR-Erfassungschips zu liefern.

6. Verfahren zum Messen eines Stroms, angewendet auf einen magnetosensitiven Eisenkern-Ringarray-Mehrring-Stromsensor, der eine erste Ringstruktur, eine zweite Ringstruktur und eine digitale Verarbeitungseinheit umfasst, **dadurch gekennzeichnet, dass** das Verfahren umfasst:
Erfassen, durch die erste Ringstruktur, eines Rückkopplungsstromsignals, das durch ein erstes Magnetfeldsignal erzeugt wird, das entsprechend einem Strom auf einem leitenden Draht in einem Eisenkern der ersten Ringstruktur erzeugt wird, und Ausgeben, durch die erste Ringstruktur, des Rückkopplungsstromsignals an die digitale Verarbeitungseinheit (401);
Messen, durch die zweite Ringstruktur, eines zweiten Magnetfeldsignals, das durch einen Strom auf dem leitenden Draht in einer Spule der zweiten Ringstruktur erzeugt wird, und Ausgeben, durch die zweite Ringstruktur, des zweiten Magnetfeldsignals an die digitale Verarbeitungseinheit (402); und
Bestimmen, durch die digitale Verarbeitungseinheit, einer charakteristischen Größe, die den Strom auf dem leitenden Draht charakterisiert, gemäß dem Rückkopplungsstromsignal und dem zweiten Magnetfeldsignal, und Bestimmen des Stroms auf dem leitenden Draht gemäß der charakteristischen Größe, die den Strom auf dem leitenden Draht (403) charakterisiert,
wobei die erste Ringstruktur eine Kompensationswicklung und eine Rückkopplungsstrom-Erfassungsschaltung umfasst, und die Kompensationswicklung um einen Eisenkern gewickelt ist, wobei das Verfahren ferner umfasst:
Ausgeben, durch die Rückkopplungsstrom-Erfassungsschaltung, des Rückkopplungsstromsignals an die Kompensationswicklung und die digitale Verarbeitungseinheit; und
Erzeugen, durch die Kompensationswicklung, eines kompensierenden Magnetfelds entsprechend dem Rückkopplungsstromsignal, Überlagern des kompensierenden Magnetfelds und des ersten Magnetfeldsignals zum Erfassen eines überlagerten ersten Magnetfeldsignals, und Halten des magnetosensitiven Eisenkern-Ringarray-Mehrring-Stromsensors in einem Null-Magnetfluss-Zustand basierend auf dem überlagerten ersten Magnetfeldsignal,
wobei die erste Ringstruktur ferner den Eisenkern umfasst, wobei der Eisenkern ein offener Eisenkern ist, der mit zwei symmetrischen Luftspalten versehen ist, und ein erster Erfassungschip für magnetischen Tunnelwiderstand (TMR-Erfassungschip) an jedem der zwei Luftspalte bereitgestellt wird,
wobei das Erfassen, durch die erste Ringstruktur, des Rückkopplungsstromsignals, das durch das erste Magnetfeldsignal erzeugt wird, das entsprechend dem Strom auf dem leitenden Draht (401) produziert wird, umfasst:
Messen, durch jeden der ersten TMR-Erfassungschips, des ersten Magnetfeldsignals; und
Mitteln, durch die Rückkopplungsstrom-Erfassungsschaltung, der ersten Magnetfeldsignale, die von den zwei ersten TMR-Erfassungschips gemessen werden, um ein gemitteltes erstes Magnetfeldsignal zu erfassen, und Erzeugen des Rückkopplungsstromsignals basierend auf dem gemittelten ersten Magnetfeldsignal.

7. Verfahren nach Anspruch 6, wobei die zweite Ringstruktur vier zweite Erfassungschips für magnetischen Tunnelwiderstand (TMR-Erfassungschips) umfasst,
wobei das Messen, durch die zweite Ringstruktur, des zweiten Magnetfeldsignals, das durch den Strom auf dem leitenden Draht in der Spule der zweiten Ringstruktur (402) erzeugt wird, umfasst:
Erfassen, durch die vier zweiten TMR-Erfassungschips, des zweiten Magnetfeldsignals, wobei die vier zweiten TMR-Erfassungschips parallel geschaltet und symmetrisch in regelmäßigen Abständen in einem ringförmigen hohlen Gehäuse bereitgestellt sind.

8. Verfahren nach Anspruch 7, wobei eine doppelschichtige Metallabschirmschicht an einer Außenseite des ringförmigen hohlen Gehäuses bereitgestellt ist.

9. Verfahren nach einem der Ansprüche 6 bis 8, wobei die digitale Verarbeitungseinheit ein Analog-Digital-Wandlermodul, ein digitales Verarbeitungsmodul und ein Digital-Analog-Wandlermodul umfasst,
wobei das Bestimmen, durch die digitale Verarbeitungseinheit, der charakteristischen Größe, die den Strom auf dem leitenden Draht charakterisiert, gemäß dem Rückkopplungsstromsignal und dem zweiten Magnetfeldsignal (403) umfasst:
Durchführen, durch das Analog-Digital-Wandlermodul, einer Analog-Digital-Wandlung an dem Rückkopplungsstromsignal und dem zweiten Magnetfeldsignal, um ein digitales Rückkopplungsstromsignal und ein digitales zweites Magnetfeldsignal zu erfassen; und
Berechnen einer charakteristischen Größe, die den Strom auf dem leitenden Draht charakterisiert, durch das digitale Verarbeitungsmodul gemäß dem digitalen Rückkopplungsstromsignal und dem digitalen zweiten Magnetfeldsignal,
wobei das Bestimmen des Stroms auf dem leitenden Draht gemäß der charakteristischen Größe, die den Strom auf dem leitenden Draht (403) charakterisiert, umfasst:
Durchführen, durch das Digital-Analog-Wandlermodul, einer Digital-Analog-Wandlung an der charakteristischen Größe, die den Strom auf dem leitenden Draht charakterisiert, um eine analoge charakteristische Größe zu erfassen, die den Strom auf dem leitenden Draht charakterisiert, und Bestimmen des Stroms auf dem leitenden Draht gemäß der analogen charakteristischen Größe, die den Strom auf dem leitenden Draht charakterisiert.

10. Verfahren nach Anspruch 9, wobei das Berechnen, durch das digitale Verarbeitungsmodul, der charakteristischen Größe, die den Strom auf dem leitenden Draht charakterisiert, gemäß dem digitalen Rückkopplungsstromsignal und dem digitalen zweiten Magnetfeldsignal mindestens eines umfasst von:
als Reaktion auf das digitale Rückkopplungsstromsignal, das sich innerhalb eines ersten voreingestellten Bereichs befindet, Korrigieren eines Exzentrizitätsfehlers in dem digitalen Rückkopplungsstromsignal basierend auf dem digitalen zweiten Magnetfeldsignal, um die charakteristische Größe zu erfassen, die den Strom auf dem leitenden Draht charakterisiert;
als Reaktion darauf, dass sich das digitale Rückkopplungsstromsignal innerhalb eines zweiten voreingestellten Bereichs befindet, Korrigieren eines Übersprechfehlers in dem digitalen zweiten Magnetfeldsignal basierend auf dem digitalen Rückkopplungsstromsignal, um die charakteristische Größe zu erfassen, die den Strom auf dem leitenden Draht charakterisiert; oder
in einem Anwendungsszenario einer transienten Antwort, Erfassen der charakteristischen Größe, die den Strom auf dem leitenden Draht charakterisiert, basierend auf einem arithmetischen Mittel des digitalen zweiten Magnetfeldsignals.

11. Verfahren nach Anspruch 6 oder 7, wobei der magnetosensitive Eisenkern-Ringarray-Mehrring-Stromsensor ferner eine Stromversorgungseinheit umfasst, wobei das Verfahren ferner umfasst:
Versorgen des ersten TMR-Erfassungschips und des zweiten TMR-Erfassungschips durch die Stromversorgungseinheit.

## Revendications

1. Capteur de courant magnéto-sensible à anneaux multiples à réseau annulaire à noyau de fer, **caractérisé en ce que** le capteur comprend une première structure annulaire (101), une seconde structure annulaire (102) et une unité de traitement numérique (103),
dans lequel la première structure annulaire (101) est gainée sur un fil conducteur et est connectée à l'unité de traitement numérique (103), et la première structure annulaire (101) est configurée pour acquérir un signal de courant de rétroaction généré par un premier signal de champ magnétique produit en fonction d'un courant sur le fil conducteur dans une noyau en fer de la première structure annulaire (101), et pour transmettre le signal de courant de rétroaction à l'unité de traitement numérique (103),
dans lequel la seconde structure annulaire (102) est gainée sur le fil conducteur et est connectée à l'unité de traitement numérique (103), et la seconde structure annulaire (102) est configurée pour mesurer un second signal de champ magnétique produit par un courant sur le fil conducteur dans une bobine de la seconde structure annulaire (102), et pour transmettre le second signal de champ magnétique à l'unité de traitement numérique (103), et
dans lequel l'unité de traitement numérique (103) est configurée pour déterminer une quantité caractéristique caractérisant le courant sur le fil conducteur en fonction du signal de courant de rétroaction et du second signal de champ magnétique, et déterminer le courant sur le fil conducteur en fonction de la quantité caractéristique caractérisant le courant sur le fil conducteur,
dans lequel la première structure annulaire (101) comprend le noyau de fer, un circuit d'acquisition de courant de rétroaction et un enroulement de compensation,
dans lequel le noyau de fer est un noyau de fer ouvert muni de deux entrefers symétriques, dans lequel une première puce de détection à magnétorésistance tunnel (TMR) est prévue au niveau de chacun des deux entrefers et est configurée pour mesurer le premier signal de champ magnétique,
dans lequel le circuit d'acquisition de courant de rétroaction est configuré pour faire la moyenne des premiers signaux de champ magnétique mesurés par les deux premières puces de détection TMR afin d'acquérir un premier signal de champ magnétique moyen, générer le signal de courant de rétroaction sur la base du premier champ magnétique moyen et transmettre le signal de courant de rétroaction à l'enroulement de compensation et à l'unité de traitement numérique (103),
dans lequel l'enroulement de compensation est enroulé uniformément autour du noyau de fer et configuré pour produire un champ magnétique de compensation en fonction du signal de courant de rétroaction, superposer le champ magnétique de compensation et le premier signal de champ magnétique pour obtenir un premier signal de champ magnétique superposé, et maintenir le capteur de courant magnéto-sensible à anneaux multiples à réseau annulaire à noyau de fer pour qu'il soit dans un état de flux magnétique nul sur la base du premier signal de champ magnétique superposé.

2. Capteur de courant magnéto-sensible à anneaux multiples à réseau annulaire à noyau de fer selon la revendication 1, dans lequel la seconde structure annulaire (102) comprend quatre secondes puces de détection de magnétorésistance à effet tunnel (TMR) qui sont connectées en parallèle et fournies symétriquement à intervalles réguliers dans un boîtier creux annulaire, dans lequel les secondes puces de détection TMR sont configurées pour acquérir le second signal de champ magnétique.

3. Capteur de courant magnéto-sensible à anneaux multiples à réseau annulaire à noyau de fer selon la revendication 2, dans lequel une couche de blindage métallique à double couche est fournie à l'extérieur du boîtier creux annulaire.

4. Capteur de courant magnéto-sensible à anneaux multiples à réseau annulaire à noyau de fer selon l'une quelconque des revendications 1 à 3, dans lequel l'unité de traitement numérique (103) comprend un module de conversion analogique-numérique, un module de traitement numérique, et un module de conversion analogique-numérique,
dans lequel le module de conversion analogique-numérique est connecté au module de traitement numérique, et est configuré pour effectuer une conversion analogique-numérique sur le signal de courant de rétroaction et le second signal de champ magnétique afin d'obtenir un signal de courant de rétroaction numérique et un second signal de champ magnétique numérique,
dans lequel le module de traitement numérique est connecté au module de conversion numérique-analogique et est configuré pour calculer une quantité caractéristique caractérisant le courant sur le fil conducteur en fonction du signal de courant de rétroaction numérique et du second signal de champ magnétique numérique,
dans lequel le module de conversion analogique-numérique est configuré pour effectuer une conversion analogique-numérique sur la quantité caractéristique caractérisant le courant sur le fil conducteur afin d'acquérir une quantité caractéristique analogique caractérisant le courant sur le fil conducteur, et déterminer le courant sur le fil conducteur en fonction de la quantité caractéristique analogique caractérisant le courant sur le fil conducteur.

5. Capteur de courant magnéto-sensible à anneaux multiples à réseau annulaire à noyau de fer selon la revendication 1 ou 2, comprenant en outre une unité d'alimentation électrique,
dans lequel l'unité d'alimentation électrique est configurée pour alimenter les premières puces de détection TMR et les secondes puces de détection TMR.

6. Procédé de mesure d'un courant magnéto-sensible à anneaux multiples à réseau annulaire à noyau de fer comprenant une première structure annulaire, une seconde structure annulaire, et une unité de traitement numérique, **caractérisé en ce que** le procédé comprend :
l'acquisition, par la première structure annulaire, d'un signal de courant de rétroaction généré par un premier signal de champ magnétique produit en fonction d'un courant sur un fil conducteur dans un noyau de fer de la première structure annulaire, et la sortie, par la première structure annulaire, du signal de courant de rétroaction vers l'unité de traitement numérique (401) ;
la mesure, par la seconde structure annulaire, d'un second signal de champ magnétique produit par un courant sur le fil conducteur dans une bobine de la seconde structure annulaire, et la sortie, par la seconde structure annulaire, du second signal de champ magnétique vers l'unité de traitement numérique (402) ; et
la détermination, par l'unité de traitement numérique, d'une quantité caractéristique caractérisant le courant sur le fil conducteur en fonction du signal de courant de rétroaction et le second signal de champ magnétique, et la détermination du courant sur le fil conducteur en fonction de la quantité caractéristique caractérisant le courant sur le fil conducteur (403)
dans lequel la première structure annulaire comprend un enroulement de compensation et un circuit d'acquisition de courant de rétroaction, et l'enroulement de compensation est enroulé autour d'un noyau de fer, dans lequel le procédé comprend en outre :
la sortie, par le circuit d'acquisition de courant de rétroaction, du signal de courant de rétroaction à l'enroulement de compensation et à l'unité de traitement numérique ; et
la génération, par l'enroulement de compensation, d'un champ magnétique de compensation en fonction du signal de courant de rétroaction, la superposition du champ magnétique de compensation et du premier signal de champ magnétique pour obtenir un premier signal de champ magnétique superposé et le maintien du capteur de courant magnéto-sensible à plusieurs anneaux à réseau annulaire à noyau de fer dans un état de flux magnétique nul sur la base du premier signal de champ magnétique superposé,
dans lequel la première structure annulaire comprend en outre le noyau de fer, dans lequel le noyau de fer est un noyau de fer ouvert pourvu de deux entrefers symétriques, et une première puce de détection de magnétorésistance à effet tunnel (TMR) est fournie au niveau de chacun des deux entrefers,
dans lequel l'acquisition, par la première structure annulaire, du signal de courant de rétroaction généré par le premier signal de champ magnétique produit en fonction du courant sur le fil conducteur (401) comprend :
la mesure, par chacune des premières puces de détection TMR, du premier signal de champ magnétique ; et
le calcul de la moyenne, par le circuit d'acquisition de courant de rétroaction, des premiers signaux de champ magnétique mesurés par les deux premières puces de détection TMR, afin d'acquérir un premier signal de champ magnétique moyen, et la génération du signal de courant de rétroaction sur la base du premier signal de champ magnétique moyen.

7. Procédé selon la revendication 6, dans lequel la seconde structure annulaire comprend quatre secondes puces de détection de magnétorésistance à effet tunnel (TMR),
dans lequel la mesure, par la seconde structure annulaire, du second signal de champ magnétique produit par le courant sur le fil conducteur dans la bobine de la seconde structure annulaire (402) comprend :
l'acquisition, par les quatre secondes puces de détection TMR, du second signal de champ magnétique, dans lequel les quatre secondes puces de détection TMR sont connectées en parallèle et fournies symétriquement à intervalles réguliers dans un boîtier creux annulaire.

8. Procédé selon la revendication 7, dans lequel une couche de blindage métallique à double couche est prévue à l'extérieur du boîtier creux annulaire.

9. Procédé selon l'une quelconque des revendications 6 à 8, dans lequel l'unité de traitement numérique comprend un module de conversion analogique-numérique, un module de traitement numérique et un module de conversion analogique-numérique,
dans lequel la détermination, par l'unité de traitement numérique, de la quantité caractéristique caractérisant le courant sur le fil conducteur en fonction du signal de courant de rétroaction et du second signal de champ magnétique (403) comprend :
l'exécution à l'aide du module de conversion analogique-numérique, d'une conversion analogique-numérique du signal de courant de rétroaction et du second signal de champ magnétique, afin d'obtenir un signal de courant de rétroaction numérique et un deuxième signal de champ magnétique numérique ; et
le calcul, par le module de traitement numérique, d'une quantité caractéristique caractérisant le courant sur le fil conducteur en fonction du signal de courant de rétroaction numérique et du second signal de champ magnétique numérique,
dans lequel la détermination du courant sur le fil conducteur en fonction de la quantité caractéristique caractérisant le courant sur le fil conducteur (403) comprend :
la réalisation, par le module de conversion analogique-numérique, d'une conversion analogique-numérique sur la quantité caractéristique caractérisant le courant sur le fil conducteur, pour obtenir une quantité caractéristique analogique caractérisant le courant sur le fil conducteur, et la détermination du courant sur le fil conducteur en fonction de la quantité caractéristique analogique la caractérisation du courant sur le fil conducteur.

10. Procédé selon la revendication 9, dans lequel le calcul, par le module de traitement numérique, de la quantité caractéristique caractérisant le courant sur le fil conducteur en fonction du signal de courant de rétroaction numérique et du second signal de champ magnétique numérique comprend au moins l'un parmi :
en réponse au fait que le signal de courant de rétroaction numérique se situe dans une première plage prédéfinie, la correction d'une erreur d'excentricité dans le signal de courant de rétroaction numérique sur la base du second signal de champ magnétique numérique, afin d'acquérir la quantité caractéristique caractérisant le courant sur le fil conducteur ;
en réponse au fait que le signal de courant de rétroaction numérique se situe dans une seconde plage prédéfinie, la correction d'une erreur de diaphonie dans le second signal de champ magnétique numérique sur la base du signal de courant de rétroaction numérique, afin d'acquérir la quantité caractéristique caractérisant le courant sur le fil conducteur ; ou
dans un scénario d'application de réponse transitoire, l'acquisition de la quantité caractéristique caractérisant le courant sur le fil conducteur sur la base d'une moyenne arithmétique du second signal de champ magnétique numérique.

11. Procédé selon la revendication 6 ou 7, dans lequel le capteur de courant magnéto-sensible à anneaux multiples à réseau annulaire à noyau de fer comprend en outre une unité d'alimentation, dans lequel le procédé comprend en outre :
l'alimentation, par l'unité d'alimentation électrique, des premières puces de détection TMR et des secondes puces de détection TMR.
